# EUROPEAN PATENT SPECIFICATION

(11) **EP 2 748 861 B1**
(45) Date of publication and mention of the grant of the patent: **21.11.2018**
(21) Application number: 12819018.8
(22) Date of filing: 10.12.2012
(51) Int. Cl.: H01L 31/055, G02B 19/00

(54) **LUMINESCENT SOLAR CONCENTRATOR WITH NANOSTRUCTURED LUMINESCENT LAYER**
LUMINESZENTER SONNENKONZENTRATOR MIT NANOSTRUKTURIERTER LUMINESZENZSCHICHT
CONCENTRATEUR SOLAIRE LUMINESCENT AYANT UNE COUCHE LUMINESCENTE NANOSTRUCTURÉE

(30) Priority: 22.12.2011 US 201161579101 P
(43) Date of publication of application: 02.07.2014
(73) Proprietor: Philips Lighting Holding B.V., 5656 AE Eindhoven (NL)
(72) Inventor: DE BOER, Dirk Kornelis Gerhardus, NL-5656 AE Eindhoven (NL); GOMEZ RIVAS, Jaime, NL-5656 AE Eindhoven (NL); RAHIMZADEH KALALEH RODRIGUEZ, Said, NL-5656 AE Eindhoven (NL); DIEDENHOFEN, Silke Luzia, NL-5656 AE Eindhoven (NL)
(74) Representative: van Eeuwijk, Alexander Henricus Waltherus
(86) International application number: PCT/IB2012/057116
(87) International publication number: WO 2013/093696

(56) References cited:
- EP-A1- 2 275 842
- WO-A2-2010/023657
- US-A1- 2010 126 566
- US-A1- 2010 126 567

## Description

### FIELD OF THE INVENTION

The invention pertains to a luminescent solar concentrator and a photovoltaic generator with at least one luminescent solar concentrator.

### BACKGROUND OF THE INVENTION

The principle of a luminescent solar concentrator (LSC) is well known in the field of photovoltaic generators. A glass or plastic sheet may contain or may be coated with some kind of luminescent material that absorbs incident light and emits light at longer wavelengths. A fraction of the emitted light of longer wavelengths is trapped inside the glass or plastic sheet by total internal reflection and guided to an edge where it is coupled into a small-area, efficient solar cell. A prior art luminescent solar concentrator is, for instance, described in document WO 2010/023657 A2. LSCs are promising because they are low-cost and can shift an operating point of the solar cell to higher light intensities.

LSCs have not yet made true their promise because of their small efficiency due to unwanted losses. These include limited absorption of sunlight, re-absorption of emitted luminescent light and escape of light not trapped by total internal reflection.

Plasmonic devices comprising nanostructured layers that make use of surface plasmonic polaritons excited by incident light to modify a wavelength dependency of emitted light are known in the art. For instance, document US 2010/0259826 A1 describes nanostructure patterns in silicon and polymer substrates, the nanostructures being coated with material that is able to support plasmonic waves, e.g. electrically conductive materials like gold, silver, chromium, titanium, copper, and aluminum. The nanostructures are described to show inter-feature distances in the order of the wavelength of light in the solar spectrum.

It is desirable to combine the advantages of the LSC concept with options provided by nanostructured layers regarding design control of emission characteristics to improve the efficiency of photovoltaic generators.

### SUMMARY OF THE INVENTION

It is therefore an object of the invention to provide a luminescent solar concentrator with an improved efficiency regarding trapping of light by internal total reflection and regarding minimized reabsorption of emitted light.

In this application, the terms "light", "electromagnetic waves" and "radiation" are used synonymously, and refer to a part of the continuous spectrum of electromagnetic waves with wavelengths that extend from below a ultraviolet region to above an infrared region, substantially characterized by an interval from 400 to 1000 nanometer (nm).

In one aspect of the present invention, the object is achieved by a luminescent solar concentrator comprising at least one luminescent device for converting incident light in at least one operating mode, wherein the luminescent device has at least one nanostructured layer and at least one luminescent member, and wherein the nanostructured layer is in close proximity to the luminescent member, and at least one light guide that is designed to guide light in a direction by total internal reflection.

WO2010/023657 discloses a luminescent solar concentrator. The luminescent solar concentrator comprises a light guide which guides light towards one or more solar cells applied at an edge of the light guide and comprises at a surface of the light guide, which is oriented perpendicular to the edge surfaces of the light guide, a sol-gel based matrix film which comprises at least a luminescent material and which may also comprise silver spheroid nano-particles have a size in the range from 10 to 40 nm which may cause an intensification of luminescent due to surface plasmon resonance. The sol-gel based matrix film is provided on a surface of the light guide on which the incident light impinges.

EP2275842 discloses nanostructure functional coatings and devices. The functional coating comprises anti-reflection properties and down-converting properties. The anti-reflection properties are obtained by an array of anti-reflection nanostructures. In an embodiment the array of anti-reflection nanostructures is provided on top of a layer which comprises the down-converting material. It has also been disclosed that the functional coating may be provided directly on a substrate which is, for example, a photovoltaic cell.

The phrase "luminescent", as used in this application, shall be understood particularly to include the features of phosphorescence and also of fluorescence. The phrase "close proximity", as used in this application, shall be understood particularly as a distance between the nanostructured layer and the luminescent member that is in the order of a wavelength of the incident and/or emitted light. This distance thus should be smaller than 700 nm, preferably smaller than 500 nm, even more preferable smaller than 400 nm. Close proximity therefore also includes a situation in which the luminescent member is applied on a surface of the nanostructured layer. It also includes the situation where the nanostructured layer is encompassed by the luminescent member.

Both absorption of incident light and emission of luminescent light can be enhanced by the nanostructured layer with an array of resonant structures at frequencies of absorption and emission. An example of resonant structures is given by dielectric particles with dimensions comparable to the wavelength of light, supporting Mie resonances. Other examples of resonant structures are metallic particles, or nanoantennas, that support localized surface plasmon polaritons (LSPPs). In the following and without loss of generality, we refer to the resonances in the structures as LSPPs and to the structures as nanoantennas. The incident light exciting the luminescent member can be resonant with the LSPPs, which allows for an enhancement of the excitation (pump enhancement) even with non-collimated light sources. By this, a luminescent solar concentrator with an improved efficiency can be provided. The absorption of incident light can in particular be tuned by changing the size and shape of the nanoantennas.

In a further aspect of the invention, the nanostructured layer comprises at least one array of nanoantennas or resonant structures. Thereby, a wide range of design options for an enhancement of the incident light and the emission of luminescent light can be provided. The array may be a one-dimensional array, wherein the nanoantennas are arranged along a straight direction that is parallel to a layer plane. In another preferred embodiment, the array may be a two-dimensional array, wherein the nanoantennas are arranged along at least two non-parallel straight directions that both are parallel to the layer plane. In still another embodiment, the array may be a three-dimensional array in which the nanoantennas of the two-dimensional array are arranged at least at two levels which have different distances with regard to the layer plane. In any one of these arrays, the nanoantennas may extend essentially in an extension direction that is perpendicular to the layer plane. The phrase "essentially", as used in this application with respect to directions, parallelism, and inclinations of planes shall be understood particularly to include a deviation from the specified direction, parallelism, or plane inclination of less than 20°, preferred of less than 15°, and especially preferred of less than 10°.

In another aspect of the invention, the nanostructured layer comprises at least one array of resonant scatterers. The term "array" is meant to be understood in the full scope of the description given above. This provides another wide range of design options for an enhancement of the incident light and the emission of luminescent light.

The efficiency of the luminescent solar concentrator can be further increased by coupling the incident light to surface lattice resonances that arise from a diffractive coupling of nanoantennas arranged in an array, i.e. individual LSPPs. By this, the emitted light can be coupled to surface lattice resonances, and thereby the intensity can be resonantly increased and controlled, both in direction and polarization of the emission. Since the strength of the coupling depends on the wavelength and the polarization, while the directionality of the emission closely resembles an angular dispersion of the surface lattice resonance, the emission characteristics like range of wavelength, direction and polarization of emitted light can be tailored by designing the array of nanoantennas adequately.

The luminescent device is provided to maximally emit electromagnetic waves in at least one operating mode at an angle that is larger than a critical angle for total internal reflection of the light guide. As a result, an improved efficiency of the luminescent solar concentrator by an improved trapping of emitted light by internal total reflection can be achieved. For a refractive index of 1.5 of the light guide material, emission of electromagnetic waves at angles above 42°, taken with respect from a vertical direction at a location of incident at a boundary to air, is preferred.

In another aspect of the present invention, in at least one operating mode of the luminescent solar concentrator, a lower limit wavelength of an emission spectrum of electromagnetic waves of the nanostructured layer is larger than an upper limit wavelength of an absorption spectrum of electromagnetic waves of the luminescent member. The phrase "lower limit wavelength", as used in this application, shall be understood particularly as the first wavelength of the emission spectrum of the nanostructured layer with an emission intensity of 10% of a maximum intensity of emission that is lower than the wavelength at which the maximum intensity occurs. The phrase "upper limit wavelength", as used in this application, shall be understood particularly as the first wavelength of the absorption spectrum of the luminescent material with a degree of absorption of 10% of a maximum absorption that is larger than the wavelength at which the maximum absorption occurs. Advantageously, reabsorption of emitted electromagnetic waves by the luminescent member could be avoided by emission in a wavelength region that does not overlap with the absorption spectrum and there could be more light available for being absorbed by a solar cell.

In a further aspect of the invention, the nanostructured layer has a periodic structure in at least one direction. The phrase "periodic structure", as used in this application, shall be understood particularly as a structure in which a certain feature thereof is repeated in regular distances in a direction. The repeated feature may include a combination of several features of the structure. These distances are preferably in a range between 100 nm and 1000 nm. The emission enhancement of luminescent light described earlier results from the coupling of the emitted light to surface lattice resonances and the coupling out of these modes to radiation. Therefore, the emission can advantageously be tuned by changing a periodicity of the array. A periodicity of the array in two non-parallel directions may advantageously give rise to a two-dimensional coverage of the light guide with emitted light.

In a preferred embodiment, the nanostructured layer of the luminescent device comprises at least one array of hetero-structured semiconductor nanowires. Manufacturing processes for this class of nanostructured material are well known to the one of skills in the art, so that costs for providing nanostructured layers for luminescent solar concentrators could be kept at a reasonable level.

In another aspect of the invention, the hetero-structured semiconductor nanowires each preferably have a top part with a diameter of less than 100 nm, and a tapered bottom part that has a bottom diameter of less than 300 nm. This shape of the nanowires may advantageously result in a distinct emission maximum.

In another aspect of the invention, the nanostructured layer has a periodic pitch of essentially 500 nm in at least one direction. The phrase "essentially", as used in this application, shall be understood particularly to include pitches in an interval of ±20%, preferably ±10% around a center pitch given by the specified value. This may give rise to an intense and distinct emission maximum at a desired wavelength.

It is another object of the invention to provide a photovoltaic generator with a luminescent solar concentrator that shows an improved efficiency. This can be attained by combining an embodiment of the luminescent solar concentrator of the invention with at least one solar cell which is optically coupled to the luminescent solar concentrator.

### BRIEF DESCRIPTION OF THE DRAWINGS

These and other aspects of the invention will be apparent from and elucidated with reference to the embodiments described hereinafter. Such embodiment does not necessarily represent the full scope of the invention, however, and reference is made therefore to the claims and herein for interpreting the scope of the invention.

In the drawings:
Fig. 1 schematically shows the prior art of a photovoltaic generator with a luminescent solar concentrator,
Fig. 2 illustrates an absorption spectrum and an emission spectrum of organic dye Lumogen Red 305 used in the luminescent solar concentrator pursuant to Fig. 1,
Fig. 3 schematically shows a photovoltaic generator with a luminescent solar concentrator in accordance with an embodiment of the invention,
Fig. 4 schematically illustrates an embodiment of a nanostructured layer for use in the luminescent solar concentrator pursuant to Fig. 3,
Fig. 5 illustrates an angular distribution of light emission of a luminescent device pursuant to Fig. 4 in two different views,
Fig. 6 illustrates a further embodiment of a nanostructured layer for use in the luminescent solar concentrator pursuant to Fig. 3, and
Fig. 7 illustrates an angular distribution of light emission of the luminescent device pursuant to Fig. 6.

### DETAILED DESCRIPTION OF EMBODIMENTS

This description may comprise several embodiments of the invention. Like features, members and functions are generally labeled with like reference numerals. For distinguishing purposes, suffixes a, b, ... are appended to the reference numerals for the various embodiments. For a missing description of the function of a like feature in one embodiment, reference is herewith made to the description of the function of that feature for the first embodiment.

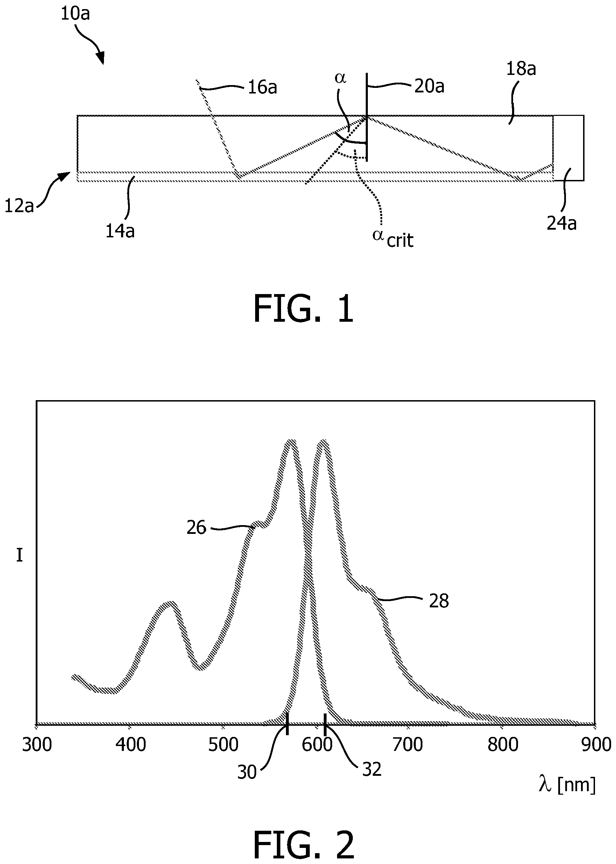

Fig. 1 schematically shows an embodiment of a photovoltaic generator 10a with a luminescent solar concentrator of the prior art.

The luminescent solar concentrator comprises a luminescent device 12a for converting incident light in an operating-ready mode. The luminescent device 12a comprises a luminescent member 14a. In the operation-ready mode, the luminescent member 14a absorbs incident light 16a (dashed line in Fig. 1) and emits light at longer wavelengths λ into a light guide 18a.

The light guide 18a is formed by a rectangular plastic sheet extending parallel to the view plane, and is disposed above the luminescent member 14a towards a direction of the incident light 16a. The light guide 18a is designed to guide light by total internal reflection in directions essentially parallel to longer edges of the rectangular sheet, provided that the light travels within the light guide 18a and approaches a boundary between the light guide 18a and the surrounding air at an angle α that is larger than a critical angle α_{crit} which is 42° for a refractive index of 1.5 of the light guide, with respect to a vertical direction 20a.

At a right end side of the light guide 18a in the view of Fig. 1, a solar cell 24a is disposed at the light guide 18a which collects the light that is trapped inside the light guide 18a by total internal reflection. The solar cell 24a is provided to convert energy of collected light to electric energy in the manner well known to the one of skills in the art.

Fig. 2 illustrates an absorption spectrum 26a and an emission spectrum 28a of an organic dye, Lumogen Red 305 (by BASF), used in the luminescent member 14a of the solar concentrator pursuant to Fig. 1. A lower limit wavelength 30a of the emission spectrum 28a of about 570 nm is smaller than an upper limit wavelength 32a of about 610 nm of the absorption spectrum 26a of the organic dye, giving rise to re-absorption of luminescent light within the luminescent member 14a, which results in a loss of efficiency. More losses occur due to escape of luminescent light emitted at an angle α that is smaller than the critical angle α_{crit}.

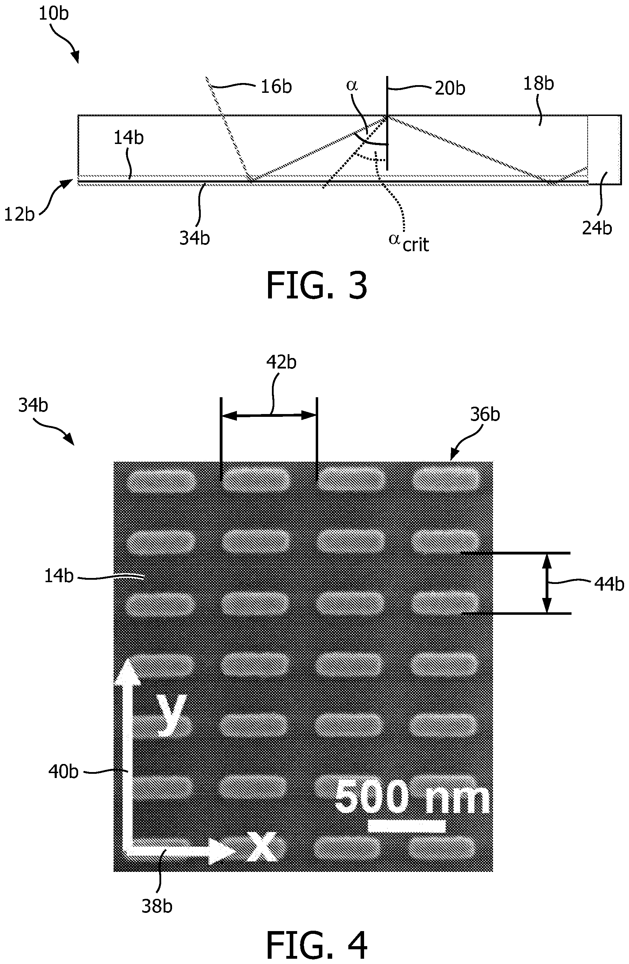

Fig. 3 shows a photovoltaic generator 10b with a luminescent solar concentrator in accordance with an embodiment of the invention. The luminescent solar concentrator comprises a luminescent device 12b for converting incident light in an operating-ready mode. The luminescent device 12b comprises a nanostructured layer 34b and a luminescent member 14b which is in contact with and thereby in close proximity to the nanostructured layer 34b.

Fig. 4 schematically illustrates an embodiment of a nanostructured layer 34b of the luminescent solar concentrator pursuant to Fig. 3. A surface of a substrate is nanostructured, comprising a two-dimensional array of plasmonic nanoantennas 36b formed by metallic silver particles, the plasmonic nanoantennas 36b extending in an extension direction that is essentially perpendicular to a plane spanned by two array dimensions 38b, 40b. The metallic silver particles have a rounded rectangular shape. The array of plasmonic nanoantennas 36b is periodic in two directions that correspond to array dimensions 38b, 40b in that a nanoantenna 36b structure is repeated with a first pitch 42b of 550 nm in the first 38b of the two array dimensions 38b, 40b and with a second pitch 44b of 350 nm in the second 40b of the two array dimensions 38b, 40b.

The array of nanoantennas 36b is in contact with a luminescent member 14b formed by a layer of cadmium selenide (CdSe)/cadmium sulfide (CdS) quantum dots. The layer of the luminescent member 14b has a thickness of 200 nm and is disposed on top of the array of nanoantennas 36b, parallel to the view plane of Fig. 4.

The array of nanoantennas 36b supports localized surface plasmon polaritons (LSPPs). The incident light 16b that excites the luminescent member 14b can be resonant with the LSPPs, which allows for an enhancement of the excitation (pump enhancement) of the luminescent member 14b even with non-collimated light sources.

An efficiency of the luminescent solar concentrator is further increased by coupling the incident light 16b to surface lattice resonances that arise from the diffractive coupling of individual LSPPs. Thereby, the emission intensity I is resonantly increased and both a directionality and a polarization of the emission is controlled. Since the strength of the coupling depends on wavelength λ and polarization, while a directionality of the emission closely resembles the angular dispersion of the surface lattice resonance, the emission characteristics like wavelength range, direction and polarization are determined by the design of the array of nanoantennas 36b. The absorption (pumping of the luminescent member 14b) can be tuned by changing the size and shape of the nanoparticles, whereas the emission of light can be tuned by changing a periodicity of the array.

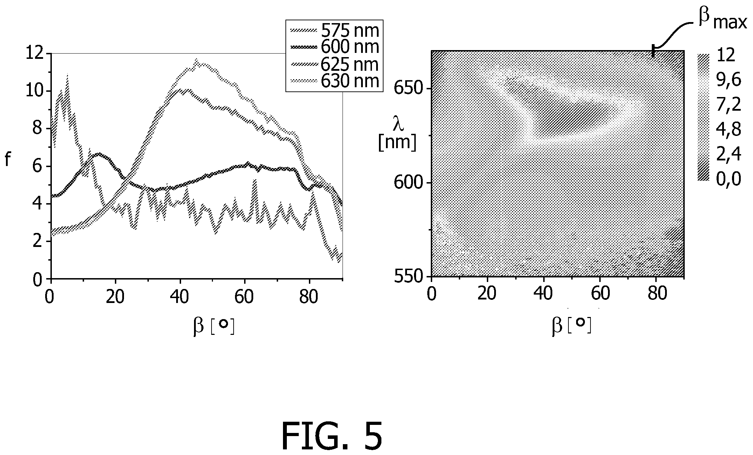

Fig. 5 illustrates an angular distribution of light emission of a luminescent device 12b pursuant to Fig. 4 in two different views. The diagram to the left of Fig. 5 shows an emission enhancement f of light in dependence of an emission angle β for various wavelengths λ. The emission enhancement f is defined as the emission of the quantum dots on top of the array of nanoantennas 36b normalized by the emission of quantum dots on top of a bare glass substrate, i.e. without the nanostructured layer 34b. For clarity, the image to the right of Fig. 5 shows a contour plot of the emission enhancement f in dependence of the emission angle β and wavelength λ.

As displayed in Fig. 5, the luminescent device 12b is provided to maximally emit electromagnetic waves in the operation-ready mode for wavelengths λ of about 630 nm at an angle βₘₐₓ that is larger than the critical angle α_{crit} for total internal reflection of a light guide 18b.

As can be appreciated from both diagrams of Fig. 5, the emission of the quantum dots is enhanced for each wavelength λ and each emission angle β. This overall emission enhancement f is the combined effect of an increase in both the pumping efficiency and the emission efficiency. The pump enhancement results from resonant scattering of the pump light by the nanoantennas 36b, since the frequency of the incident light 16b coincides with that of a localized surface plasmon resonance in the array.

It is important to note here that localized surface plasmon resonances can be excited for any angle of incidence, which makes excitation feasible also with a non-collimated light source, such as diffuse sunlight.

The emission enhancement f results from the coupling of the emitted light to surface lattice resonances and the coupling out of these modes to radiation. The emission enhancement f depends strongly on the emission angle β and the wavelength λ, as dictated by the dispersion of the surface lattice resonances to which the emitted light couples. For instance, at 575 nm there is a 10-fold emission enhancement f in the forward direction (β = 0°). At a wavelength λ of 600 nm, the emission is more or less homogeneous at all emission angles β with an emission enhancement f in the range of 4.5 to 6.5. At a wavelength λ of 630 nm, a 12-fold emission enhancement f at an angle β of 45° with respect to the sample normal is observed. Therefore, it is possible to design arrays of nanoantennas 36b that enhance and direct the emission of a luminescent member 14b in a defined manner.

It is clear from the description above without further describing another embodiment in detail that this invention can be applied with advantage in an embodiment comprising a luminescent device 12c with a nanostructured layer 34c pursuant to Fig. 4 and with a luminescent member 14c of the prior art luminescent solar concentrator pursuant to Fig. 1. The nanostructured layer 34c in this case would be provided to enhance emission in a wavelength λ range in which reabsorption by the luminescent member 14c could be avoided by having the emission spectrum 28c not overlapping the absorption spectrum 26c; i.e. by tuning a lower limit wavelength 30c of the emission spectrum 28c of electromagnetic waves of the nanostructured layer 34c to be larger than an upper limit wavelength 32c of the absorption spectrum 26c of electromagnetic waves of the luminescent member 14c, respresented by Lumogen Red 305. A wavelength λ range of about 630 nm to 700 nm would be suitable to accomplish the desired effect.

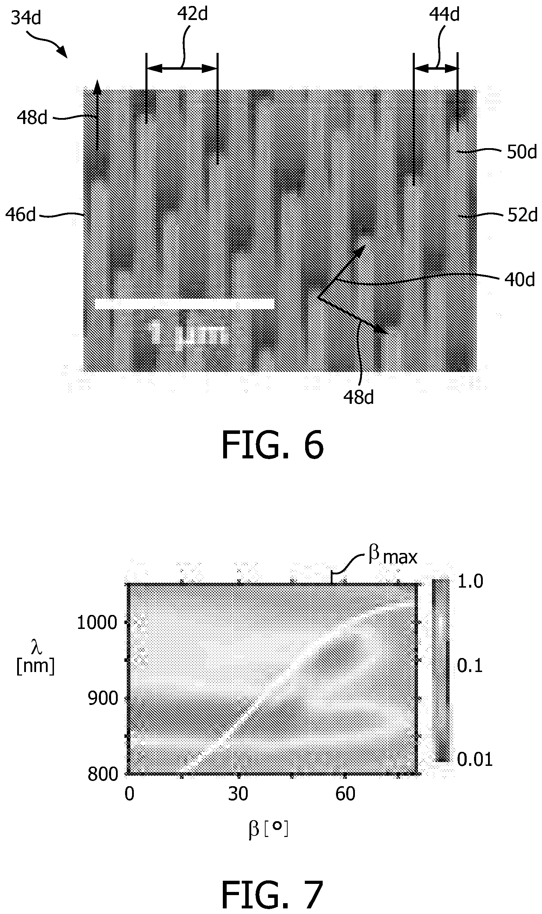

A further embodiment of a luminescent device 12d for use in the luminescent solar concentrator pursuant to Fig. 3 is illustrated in Fig. 6, showing an SEM (scanning electron micrograph) picture of a nanostructured layer 34d of the luminescent device 12d comprising an array of hetero-structured semiconductor nanowires 46d.

Semiconductor nanowires 46d are grown standardly by chemical vapor deposition (CVD) techniques such as metal-organic vapor phase epitaxy (MOVPE) or molecular beam epitaxy (MBE) on crystalline substrates for epitaxial growth. Usually, the growth of the nanowires 46d is catalyzed by a metal catalyst particle that defines the diameter of the nanowires 46d. The metal catalyst particle can be structured by substrate-conformal imprint lithography (SCIL) for fabricating ordered arrays of nanowires 46d. Nanowires 46d grow preferentially in the <111> crystallographic direction, so that nanowires 46d grown on (111) substrates are vertically aligned.

Each one of the hetero-structured semiconductor nanowires 46d comprises a first section made from indium phosphide (InP) and a second, smaller section made from indium arsenide phosphide (InAsP) which functions as a luminescent member 14d. The two sections cannot be distinguished in the SEM image. The sections are arranged consecutively in a direction of extension 48d of the nanowires 46d.

The array of hetero-structured semiconductor nanowires 46d has a periodic structure in two non-parallel directions that correspond to array dimensions 38d, 40d. The nanowires 46d are grown in a square lattice with pitches 42d, 44d of 513 nm. The top part 50d of the nanowires 46d is grown straight with a diameter of 90 nm and a length of 2 µm; the bottom part 52d is tapered with a length of 1 µm and a bottom diameter of 270 nm.

The image of Fig. 7 shows a photoluminescence plot of this array of InP nanowires as a function of emission angle β and wavelength λ. The most interesting feature of the photoluminescence is the emission of the InAsP segment at wavelengths λ > 900 nm. As is apparent from Fig. 7, there are two intense and closely spaced bands that lead to a distinct maximum of light emission around an emission angle βₘₐₓ of 57° and a wavelength λ of 956 nm. These distinct maxima of light are due to the periodic structure of the array of nanowires 46d. The importance of the periodic structure on the emission profile is illustrated by calculating the Bloch modes of a photonic crystal composed of infinitely long non-absorbing cylinders with a diameter of 90 nm and a spacing of 513 nm for comparison. The white curve in Fig. 7 shows the calculated 2nd frequency band of the photonic crystal. The good agreement between the band structure calculation and the photoluminescence indicates the relevance of the periodic structure in the definition of the directional light emission. The agreement justifies the following explanation for the emission of the array: The photoexcited nanowires 46d and InAsP sections decay preferentially into natural oscillations ("eigenmodes") of the periodic structure, which are coupled at the interfaces to free space radiation.

The theoretical background given herein is deemed to be at today's level of knowledge. Future changes in the theoretical understanding of involved phenomena shall not affect the validity of the described invention.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

### REFERENCE SYMBOL LIST

- 10: photovoltaic generator
- 12: luminescent device
- 14: luminescent member
- 16: incident light
- 18: light guide
- 20: vertical direction
- 24: solar cell
- 26: absorption spectrum
- 28: emission spectrum
- 30: lower limit wavelength
- 32: upper limit wavelength
- 34: nanostructured layer
- 36: nanoantennas
- 38: array dimension
- 40: array dimension
- 42: pitch
- 44: pitch
- 46: nanowire
- 48: direction of extension
- 50: top part
- 52: bottom part
- α: angle
- α_{crit}: critical angle
- f: emission enhancement
- I: intensity
- β: emission angle
- βₘₐₓ: angle of max. emission
- λ: wavelength

## Claims

1. A luminescent solar concentrator, comprising:
at least one luminescent device (12) for converting incident light (16) in at least one operating mode, wherein the luminescent device (12) has at least one nanostructured layer (34) and at least one luminescent member (14), and wherein a distance between the nanostructured layer (34) and the luminescent member (14) is smaller than 700 nanometer; and
at least one light guide (18) that is designed to guide light in a direction essentially parallel to longer edges of the light guide by total internal reflection towards a solar cell,
wherein the at least one light guide has a light incident surface for receiving incident light, wherein the at least one light guide has an opposite surface that is arranged opposite to the light incident surface, wherein the luminescent device is provided at the opposite surface and wherein the luminescent member is provided in between the opposite surface and the nanostructured layer, **characterized in that** the nanostructured layer of the luminescent device (12) comprises an array which has a periodicity, and the periodicity is selected to provide a maximal emission of electromagnetic waves in at least one operating mode at an emission angle (βmax) that is larger than a critical angle (αcrit) for total internal reflection of the light guide (18), the angle taken with respect from a vertical direction at a location of incident at a boundary to air.

2. The luminescent solar concentrator as claimed in claim 1, wherein the nanostructured layer (34) comprises at least one array of plasmonic nanoantennas (36).

3. The luminescent solar concentrator as claimed in claim 1, wherein the nanostructured layer (34) comprises at least one array of resonant scatterers.

4. The luminescent solar concentrator as claimed in one of the preceding claims, wherein in at least one operating mode, a lower limit wavelength (30) of an emission spectrum (28) of electromagnetic waves of the nanostructured layer (34) is larger than an upper limit wavelength (32) of an absorption spectrum (26) of electromagnetic waves of the luminescent member (14), the lower limit wavelength (30) being defined as the first wavelength of the emission spectrum with an emission intensity of 10% of a maximum intensity of the emission spectrum and the lower limit wavelength is lower than the wavelength at which the maximum intensity occurs, the upper limit wavelength being defined as the first wavelength of the absorption spectrum with a degree of absorption of 10% of a maximum absorption and upper limit wavelength is larger than the wavelength at which the maximum absorption occurs.

5. The luminescent solar concentrator as claimed in one of the preceding claims, wherein the nanostructured layer (34) has a periodic structure in at least one direction.

6. The luminescent solar concentrator as claimed in one of the preceding claims, wherein the nanostructured layer (34) of the luminescent device (12) comprises at least one array of hetero-structured semiconductor nanowires (46).

7. The luminescent solar concentrator as claimed in claim 6, wherein each of the hetero-structured semiconductor nanowires (46) has a top part (50) with a diameter of less than 100 nm and a tapered bottom part (52) that has a bottom diameter of less than 300 nm.

8. The luminescent solar concentrator as claimed in claims6 or 7, wherein the nanostructured layer (34) has a periodic pitch (42, 44) essentially of 500 nm in at least one direction.

9. A photovoltaic generator (10), comprising:
at least one luminescent solar concentrator as claimed in one of the preceding claims, and
at least one solar cell (24) which is optically coupled to the luminescent solar concentrator.

## Patentansprüche

1. Lumineszenter Sonnenkonzentrator, umfassend:
mindestens eine Lumineszenzvorrichtung (12) zum Umwandeln von einfallendem Licht (16) in mindestens einen Betriebsmodus, wobei die Lumineszenzvorrichtung (12) mindestens eine nanostrukturierte Schicht (34) und mindestens ein Lumineszenzelement (14) aufweist, und wobei ein Abstand zwischen der nanostrukturierten Schicht (34) und dem Lumineszenzelement (14) kleiner als 700 Nanometer ist; und
mindestens einen Lichtleiter (18), der konzipiert ist, um Licht in einer Richtung, die im Wesentlichen parallel zu längeren Kanten des Lichtleiters verläuft, durch Totalreflexion auf eine Solarzelle zu leiten,
wobei der mindestens eine Lichtleiter eine Lichteinfallsfläche zum Empfangen von einfallendem Licht aufweist,
wobei der mindestens eine Lichtleiter eine gegenüberliegende Fläche aufweist, die gegenüber der Lichteinfallsfläche angeordnet ist, wobei die Lumineszenzvorrichtung auf der gegenüberliegenden Fläche vorgesehen ist und wobei das Luminezenzelement zwischen der gegenüberliegenden Fläche und der nanostrukturierten Schicht vorgesehen ist,
**dadurch gekennzeichnet, dass** die nanostrukturierte Schicht der Lumineszenzvotrichtung (12) ein Array umfasst, das eine Periodizität aufweist, und dass die Periodizität ausgewählt ist, um eine maximale Emission von elektromagnetischen Wellen in mindestens einem Betriebsmodus unter einem Emissionswinkel (βmax) bereitzustellen, der größer ist als ein kritischer Winkel (acrit) für die Totalreflexion des Lichtleiters (18), wobei der Winkel in Bezug auf eine vertikale Richtung am Einfallsort an einer Grenze zu Luft gebildet wird.

2. Lumineszenter Sonnenkonzentrator nach Anspruch 1, wobei die nanostrukturierte Schicht (34) mindestens ein Array aus plasmonischen Nanoantennen (36) umfasst.

3. Lumineszenter Sonnenkonzentrator nach Anspruch 1, wobei die nanostrukturierte Schicht (34) mindestens ein Array aus resonanten Streuern umfasst.

4. Lumineszenter Sonnenkonzentrator nach einem der vorhergehenden Ansprüche, wobei in mindestens einem Betriebsmodus eine untere Grenzwellenlänge (30) eines Emissionsspektrums (28) von elektromagnetischen Wellen der nanostrukturierten Schicht (34) größer ist als eine obere Grenzwellenlänge (32) eines Absorptionsspektrums (26) von elektromagnetischen Wellen des Lumineszenzelements (14), wobei die untere Grenzwellenlänge (30) als die erste Wellenlänge des Emissionsspektrums mit einer Emissionsintensität von 10 % der maximalen Intensität des Emissionsspektrums definiert ist und die untere Grenzwellenlänge kleiner ist als die Wellenlänge, bei der die maximale Intensität auftritt, wobei die obere Grenzwellenlänge als die erste Wellenlänge des Absorptionsspektrums mit einem Absorptionsgrad von 10 % der maximalen Absorption definiert ist und die obere Grenzwellenlänge größer ist als die Wellenlänge, bei der die maximale Absorption auftritt.

5. Lumineszenter Sonnenkonzentrator nach einem der vorhergehenden Ansprüche, wobei die nanostrukturierte Schicht (34) eine periodische Struktur in mindestens einer Richtung aufweist.

6. Lumineszenter Sonnenkonzentrator nach einem der vorhergehenden Ansprüche, wobei die nanostrukturierte Schicht (34) der Lumineszenzvorrichtung (12) mindestens ein Array aus heterostrukturierten Halbleiter-Nanodrähten (46) aufweist.

7. Lumineszenter Sonnenkonzentrator nach einem der vorhergehenden Ansprüche, wobei jeder der heterostrukturierten Halbleiter-Nanodrähte (46) einen oberen Teil (50) mit einem Durchmesser von weniger als 100 nm und einen sich verjüngenden unteren Teil (52) mit einem unteren Durchmesser von weniger als 300 nm aufweist.

8. Lumineszenter Sonnenkonzentrator nach Anspruch 6 oder 7, wobei die nanostrukturierte Schicht (34) einem periodischen Abstand (42, 44) im Wesentlichen von 500 nm in mindestens einer Richtung aufweist.

9. Photovoltaikgenerator (10), umfassend:
mindestens eine lumineszenten Sonnenkonzentrator nach einem der vorhergehenden Ansprüche, und
mindestens eine Solarzelle (24), die mit dem lumineszenten Sonnenkonzentrator optisch gekoppelt ist.

## Revendications

1. Concentrateur solaire luminescent, comprenant :
au moins un dispositif luminescent (12) pour transformer une lumière incidente (16) dans au moins un mode de fonctionnement, dans lequel le dispositif luminescent (12) a au moins une couche nanostructurée (34) et au moins un élément luminescent (14), et dans lequel une distance entre la couche nanostructurée (34) et l'élément luminescent (14) est plus petite que 700 nanomètres ; et
au moins un guide de lumière (18) qui est conçu pour guider la lumière dans une direction sensiblement parallèle aux bords plus longs du guide de lumière par réflexion interne totale vers une cellule solaire,
dans lequel l'au moins un guide de lumière a une surface d'incidence de lumière pour recevoir la lumière incidente, dans lequel l'au moins un guide de lumière a une surface opposée qui est agencée à l'opposé de la surface d'incidence de lumière, dans lequel le dispositif luminescent est prévu au niveau de la surface opposée et dans lequel l'élément luminescent est prévu au milieu de la surface opposée et de la couche nanostructurée,
**caractérisé en ce que**
la couche nanostructurée du dispositif luminescent (12) comprend un groupement qui a une périodicité, et la périodicité est sélectionnée pour fournir une émission maximale d'ondes électromagnétiques dans au moins un mode de fonctionnement à un angle d'émission (βmax) qui est plus grand qu'un angle critique (acrit) pour réflexion interne totale du guide de lumière (18), l'angle étant pris par rapport à une direction verticale au niveau d'un emplacement d'incidence au niveau d'une frontière avec l'air.

2. Concentrateur solaire luminescent selon la revendication 1, dans lequel la couche nanostructurée (34) comprend au moins un groupement de nanoantennes plasmoniques (36).

3. Concentrateur solaire luminescent selon la revendication 1, dans lequel la couche nanostructurée (34) comprend au moins un groupement de diffuseurs résonants.

4. Concentrateur solaire luminescent selon l'une des revendications précédentes, dans lequel dans au moins un mode de fonctionnement, une longueur d'onde de limite inférieure (30) d'un spectre d'émission (28) d'ondes électromagnétiques de la couche nanostructurée (34) est plus grande qu'une longueur d'onde de limite supérieure (32) d'un spectre d'absorption (26) d'ondes électromagnétiques de l'élément luminescent (14), la longueur d'onde de limite inférieure (30) étant définie comme la première longueur d'onde du spectre d'émission avec une intensité d'émission de 10 % d'une intensité maximale du spectre d'émission et la longueur d'onde de limite inférieure est inférieure à la longueur d'onde à laquelle l'intensité maximale se produit, la longueur d'onde de limite supérieure étant définie comme la première longueur d'onde du spectre d'absorption avec un degré d'absorption de 10 % d'une absorption maximale et la longueur d'onde de limite supérieure maximale est plus grande que la longueur d'onde à laquelle l'absorption maximale se produit.

5. Concentrateur solaire luminescent selon l'une des revendications précédentes, dans lequel la couche nanostructurée (34) a une structure périodique dans au moins une direction.

6. Concentrateur solaire luminescent selon l'une des revendications précédentes, dans lequel la couche nanostructurée (34) du dispositif luminescent (12) comprend au moins un groupement de nanofils à semi-conducteur à hétérostructure (46).

7. Concentrateur solaire luminescent selon la revendication 6, dans lequel chacun des nanofils à semi-conducteur à hétérostructure (46) a une partie supérieure (50) ayant un diamètre de moins de 100 nm et une partie inférieure tronconique (52) qui a un diamètre inférieur de moins de 300 nm.

8. Concentrateur solaire luminescent selon les revendications 6 ou 7, dans lequel la couche nanostructurée (34) a un intervalle périodique (42, 44) de sensiblement 500 nm dans au moins une direction.

9. Générateur photovoltaïque (10), comprenant :
au moins un concentrateur solaire luminescent selon l'une des revendications précédentes, et
au moins une cellule solaire (24) qui est couplée de façon optique au concentrateur solaire luminescent.
